# EUROPÄISCHE PATENTANMELDUNG

(11) **EP 1 323 798 A1**
(43) Veröffentlichungstag der Anmeldung: **02.07.2003**
(21) Anmeldenummer: 02028034.3
(22) Anmeldetag: 16.12.2002
(51) Int. Cl.: C09G 1/02, H01L 21/321

(54) **Zusammensetzung für das chemisch-mechanische Polieren von Metall- und Metall-Dielektrikastrukturen**

(30) Priorität: 27.12.2001 DE 10164262
(71) Anmelder: Bayer Aktiengesellschaft, 51368 Leverkusen (DE)
(72) Erfinder: Puppe, Lothar, Dr., 51399 Burscheid (DE); Passing, Gerd, Dr., 50354 Hürth (DE); Tsai, Ming-Shih, Hsinchu 30050 (TW)

(57) **Zusammenfassung**

Eine Zusammensetzung enthaltend 2,5 bis 70 Vol.-% eines 30 Gew.-% kationisch modifizierten Kieselsols, dessen kationisch modifizierte SiO₂-Partikel eine mittlere Teilchengröße von 12 bis 300 nm haben, sowie 0,5 bis 22 Gew.-% an mindestens einem Oxidationsmittel, mit einem pH-Wert von 2,5 bis 6 eignet sich hervorragend als Polierslurry für das chemisch-mechanische Polieren von Metall- und Metall/Dielektrika-Strukturen.

## Beschreibung

Die vorliegende Erfindung betrifft eine Zusammensetzung für das chemisch-mechanische Polieren (CMP) von Metall- und Dielektrikastrukturen mit hoher Cu-Abtragsrate, ein Verfahren zu ihrer Herstellung und ihre Verwendung.

Integrierte Halbleiterschaltungen (IC) bestehen aus strukturierten halbleitenden, nichtleitenden und elektrisch leitfähigen dünnen Schichten. Diese strukturierten Schichten werden üblicherweise dadurch hergestellt, dass ein Schichtmaterial, z. B. durch Aufdampfen aufgebracht und durch ein mikrolithographisches Verfahren strukturiert wird. Durch die Kombination der verschiedenen halbleitenden, nicht leitenden und leitenden Schichtmaterialien werden die elektronischen Schaltungselemente des IC, wie z. B. Transistoren, Kondensatoren, Widerstände und Verdrahtungen erzeugt.

Die Qualität eines IC und seiner Funktion hängt in entscheidendem Maße von der Präzision ab, mit der die verschiedenen Schichtmaterialien aufgebracht und strukturiert werden können.

Mit steigender Schichtenanzahl nimmt jedoch die Planarität der Schichten deutlich ab. Dies führt ab einer bestimmten Schichtenanzahl zum Versagen einer oder mehrerer Funktionselemente des IC und damit zum Versagen des gesamten IC.

Die Verringerung der Planarität der Schichten ist Folge des Aufbaus neuer Schichten, wenn diese auf bereits strukturierte Schichten aufgebracht werden müssen. Durch die Strukturierung entstehen Höhenunterschiede, die bis zu 0,6 µm pro Schicht betragen können. Diese Höhenunterschiede addieren sich von Schicht zu Schicht und bewirken, dass die darauffolgende Schicht nicht mehr auf eine planare sondern auf eine unebene Fläche aufgebracht werden muss. Eine erste Folge ist, dass die nachfolgend aufgebrachte Schicht eine ungleichmäßige Dicke aufweist. In extremen Fällen entstehen so Fehlstellen, Defekte in den elektronischen Funktionselementen und mangelnde Kontakte. Unebene Flächen führen zudem zu Problemen bei der Strukturierung. Um ausreichend kleine Strukturen erzeugen zu können, ist eine extrem hohe Abbildungsgenauigkeit (DOF, depth of focus) im mikrolithographischen Verfahrensschritt notwendig. Diese Strukturen können jedoch nur in einer Ebene scharf abgebildet werden; je stärker Stellen von dieser Ebene abweichen, desto unschärfer ist die Abbildung.

Zur Lösung dieses Problems wird das sogenannte chemisch-mechanische Polieren (CMP) durchgeführt. Das CMP bewirkt eine globale Planarisierung der strukturierten Oberfläche durch Abtrag erhöhter Schichtteile, bis eine ebene Schicht erhalten wird. Hierdurch kann der nächstfolgende Schichtaufbau auf einer ebenen Fläche ohne Höhenunterschiede erfolgen, und die Präzision der Strukturierung und die Funktionsfähigkeit der Elemente des IC bleiben erhalten.

Ein CMP-Schritt wird mit Hilfe von speziellen Poliermaschinen, Poliertüchern (Pads) und Poliermitteln (Polierslurries) durchgeführt. Eine Polierslurry ist eine Zusammensetzung, die in Kombination mit dem Poliertuch, dem sogenannten Pad auf der Poliermaschine einen Abtrag des zu polierenden Materials bewirkt.

Ein Wafer ist eine polierte Siliciumscheibe, auf der integrierte Schaltungen aufgebaut werden.

Eine Übersicht über die Technik des CMP findet sich z.B. in B. L. Mueller, J. S. Steckenrider Chemtech (1998) S. 38- 46.

Insbesondere in Polierschritten, in denen Halbleiterschichten beteiligt sind, sind die Anforderungen an die Präzision des Polierschrittes und damit an die Polierslurry besonders groß.

Bewertungsmaßstab für die Wirksamkeit von Polierslurries sind eine Reihe von Größen, mit denen die Wirkung der Polierslurry charakterisiert wird. Hierzu gehören die Abtragsrate, d.h. die Geschwindigkeit mit der das zu polierende Material abgetragen wird, die Selektivität, d.h. das Verhältnis der Abtragsgeschwindigkeiten von zu polierenden Material zu weiteren anwesenden Materialien, sowie Größen für die Gleichmäßigkeit der Planarisierung. Als Größen für die Gleichmäßigkeit der Planarisierung werden üblicherweise die Gleichmäßigkeit der Restschichtdicke innerhalb eines Wafers (WIWNU) und die Gleichmäßigkeit von Wafer zu Wafer (WTWNU) sowie die Anzahl der Defekte pro Flächeneinheit verwendet.

Für die Herstellung von integrierten Schaltungen (Integrated Circuits, IC) wird zunehmend der sogenannte Cu-Damascene-Prozess verwendet (vgl. z.B. "Microchip Fabrication: A Practical Guide to Semiconductor Processing", Peter Van Zant, 4^{th} ed., McGraw-Hill, 2000, pp 401 - 403 und 302 - 309 und "Copper CMP: A Question of Tradeoffs", Peter Singer, Semiconductor International, Verlag Cahners, Mai 2000, pp 73 - 84). Dabei ist es erforderlich, eine Cu-Schicht chemisch-mechanisch mit einer Polierslurry abzutragen (sog. Cu-CMP-Prozess), um die Cu-Leiterbahnen herzustellen. Die fertigen Cu-Leiterbahnen sind in ein Dielektrikum eingebettet. Zwischen Cu und dem Dielektrikum befindet sich eine Barriereschicht. Stand der Technik für den Cu-CMP-Prozess ist ein Zwei-Schritt Prozess. D. h., dass die Cu-Schicht zuerst mit einer Polierslurry poliert wird, die einen hohen Cu-Abtrag garantiert. Anschließend wird eine zweite Polierslurry verwendet, um die endgültige ebene Oberfläche mit dem blank polierten Dielektrikum und den eingebetteten Leiterbahnen herzustellen.

Für den ersten Polierschritt verwendet man eine Polierslurry mit hoher Selektivität, d. h., dass die Abtragsrate für Cu möglichst hoch ist und die für das Material der darunter liegenden Barriereschicht möglichst klein ist. Der Polierprozess wird automatisch gestoppt, sobald unter dem Cu die Barriereschicht freigelegt wird.

Die Barriereschicht wird anschließend in einem zweiten Polierschritt entfernt. Hierzu verwendet man Polierslurries mit hoher Abtragsrate für die Barriereschicht. Die Abtragsrate für Cu ist kleiner oder gleich der Abtragsrate für die der Barriereschicht.

Aus dem Stand der Technik ist bekannt als Abrasive in Polierslurries für den ersten Polierschritt z. B. Titanoxid, Siliciumoxid oder Aluminiumoxid einzusetzen (vgl. z.B. WO-A 99/64527, WO-A 99/67056, US-A 5,575,837 und WO-A 00/00567). Nachteilig an Polierslurries die Aluminiumoxid enthalten ist dessen hohe Härte, was verstärkt zu Kratzern auf der Waferoberfläche führt. Dieser Effekt kann reduziert werden, indem man das Aluminiumoxid über Gasphasenprozesse und nicht über Schmelzprozesse herstellt. Bei diesem Prozess erhält man unregelmäßig geformte Partikel, die aus vielen kleinen Primärpartikeln (Aggregate) zusammengesintert sind. Der Gasphasenprozess kann auch zur Herstellung von Titandioxid- oder Siliciumdioxidteilchen verwendet werden. Kantige Teilchen kratzen prinzipiell stärker als runde, kugelförmige Teilchen.

Kieselsolteilchen sind einzelne, nicht agglomerierte oder aggregierte runde kugelförmige Teilchen mit negativer Oberflächenladung. Sie sind amorph und ihre Dichte ist geringer als die von SiO₂-Teilchen aus Gasphasenprozessen. Demzufolge sind Kieselsolteilchen weicher. Kieselsolteilchen bieten daher von ihrer Kornform und Weichheit her die beste Voraussetzung eine Polierslurry herzustellen, die nicht die weiche Cu-Oberfläche verkratzt.

Aus WO-A 99/67056 ist bekannt ein mit Aluminat-Ionen modifiziertes Kieselsol, das mit Na-Ionen stabilisiert ist, zu verwenden. Hohe Gehalte an Na-Ionen sind in der flüssigen Phase von Polierslurries für das chemisch-mechanische Polieren von integrierten Schaltungen jedoch nicht erwünscht.

Aus EP-A 1 000 995 ist weiterhin bekannt, kationisch modifizierte Kieselsole zum Polieren von Dielektrikastrukturen einzusetzen, wobei allerdings keine Oxidationsmittel zugesetzt werden. Selektivitäten von Metall : Barriereschicht werden nicht erwähnt.

Die aus oben genanntem Stand der Technik bekannten Polierslurries weisen alle den Nachteil auf, dass die Selektivitäten, insbesondere die von Metall : Barriereschicht, über eine Kombination mehrerer Zusätze, z. B. Filmbildner oder organischen Verbindungen, eingestellt werden müssen und die vom Abrasiv und pH-Wert nur in Anwesenheit eines Oxidationsmittels vorgegebene Selektivität von Metall : Barriereschicht zu niedrig (< 20:1) ist.

Es bestand daher die Aufgabe, eine gegenüber dem Stand der Technik verbesserte Zusammensetzung auf Basis von Kieselsol bereitzustellen, die für das chemisch-mechanische Polieren von Metall- und Metall/Dielektrikastrukturen geeignet ist, mit einer hohen Metall-Abtragsrate von ≥ 3000 Å/min und einer Selektivität von Metall:Barriereschicht von 20:1 oder größer.

Überraschend wurde nun gefunden, dass diese Aufgabe mit einer Zusammensetzung gelöst wird, die ein Kieselsol mit einer positiven Oberflächenladung als Abrasiv und ein Oxidationsmittel enthält und einen sauren pH-Wert aufweist.

Gegenstand der Erfindung ist daher eine Zusammensetzung enthaltend 2,5 bis 70 Vol.-% eines 30 Gew.-% kationisch modifizierten SiO₂ enthaltenden Kieselsols, dessen kationisch modifizierte SiO₂-Partikel eine mittlere Teilchengröße von 12 bis 300 nm haben, sowie 0,05 bis 22 Gew.-% an mindestens einem Oxidationsmittel, mit einem pH-Wert von 2,5 bis 6.

Im Sinne der vorliegenden Erfindung gelten folgende Begriffsbestimmungen.

Der Begriff Metall umfasst die Elemente W, Al, Cu, Ru, Pt und Ir und/oder deren Legierungen, Carbide und/oder Carbonitride.

Der Begriff Dielektrikum umfasst organische und nicht organische Dielektrika. Beispiele für organische Dielektrika sind SiLK™ (Dow Chemical Company), Polyimide, fluorierte Polyimide, diamantartige Kohlenstoffe, Polyarylether, Polyarylene, Parylen N, Cyclotene, Polynorbonene und Teflon. Nichtorganische Dielektrika basieren z. B. auf SiO₂-Glas als Hauptbestandteil. Nebenbestandteile können Fluor, Phosphor, Bor und/oder Kohlenstoff sein. Gebräuchliche Bezeichnungen für diese Dielektrika sind z. B. FSG, PSG, BSG oder BPSG, wobei SG für "spin on glass" steht. Für die Herstellung dieser Dielektrika-Schichten sind verschiedene Herstellungsverfahren bekannt (vgl. z.B. Peter Van Zant, 4^{th} ed., McGraw-Hill, 2000, S. 363- 376 und S. 389 - 391). Außerdem sind Silsesquioxane (HSQ, MSQ) als Dielektrika bekannt, die stark polymerisiert sind und dem anorganischen Zustand angenähert wurden.

Der Begriff Barriereschicht umfasst Schichten aus Ta, TaSi, TaN, TaSiN, Ti, TiN, WN, WSiN, SiC, Siliciumoxinitrid, Siliciumoxicarbid mit Sauerstoff als Nebenbestandteil, Siliciumoxicarbonitrid und/oder Si₃N₄.

Das in der erfindungsgemäßen Zusammensetzung eingesetzte Kieselsol ist ein kationisch modifiziertes Sol, bestehend aus einer wässrigen, sauren Suspension von kolloidalem Kieselsol, dessen SiO₂-Partikel an der Oberfläche positiv geladen sind. Die Oberflächenmodifikation kann durch Umsetzung von nicht modifizierten Kieselsolen mit löslichen, tri- oder tetravalente Metalloxiden, -oxchloriden,-oxyhydraten,nitraten, -sulfaten, -oxisulfaten und/oder -oxalaten erzeugt werden, wobei als Metalle z.B. Al, B, Fe, Ti, Zr, Ga, Mn und/oder In in Frage kommen. Erfindungsgemäß bevorzugt sind Aluminiumoxid-modifizierte Kieselsole. Derartige Kieselsole sind bekannt (vgl. z.B. R.K. Iler, "The Chemistry of Silica", John Wiley & Sons, S. 410 - 411). Beispiele für Gegen-Ionen sind CH₃COO⁻, NO₃⁻, Cl⁻ oder SO₄²⁻. Bevorzugtes Gegenion ist CH₃COO⁻. Die Primärpartikel des Kieselsols sind nicht aggregiert oder agglomeriert.

Die in der erfindungsgemäßen Zusammensetzung enthaltenen kationisch modifizierten Kieselsole können z.B. hergestellt werden, indem man zunächst die tri- oder tetravalenten Metalloxide, -oxichloride, -oxihydrate, -nitrate, -sulfate, -oxisulfate und/oder -oxalate, vorzugsweise Aluminiumhydroxichlorid, in Wasser löst, anschließend gegebenenfalls Essigsäure zusetzt und dann mit einem alkalischen Kieselsol, welches gegebenenfalls durch Natrium- oder vorzugsweise Kaliumionen stabilisiert ist, unter Rühren vermischt. Der pH-Wert des stabilen kationisch modifizierten Kieselsols liegt zwischen 2,5 und 6. Die Menge an tri- oder tetravalente Metalloxiden, - oxichloriden,-oxihydraten, -nitraten, -sulfaten, -oxisulfaten und/oder -oxalaten wird bevorzugt so bemessen, dass eine vollständige Belegung der Oberfläche der SiO₂-Teilchen erfolgt.

Eine ebenfalls geeignete Herstellungsvariante für das kationische Kieselsol besteht darin, dass die Al-Modifizierung am alkalisch stabilisierten Kieselsol vorgenommen wird und anschließend eine Umladung über saure Ionenaustauscher-Harze erfolgt. Gegebenenfalls können dem sauren Kieselsol weitere Anteile an Säuren zugesetzt werden, um den erforderlichen pH-Wert einzustellen.

Die mittlere Teilchengröße der kationisch modifizierten SiO₂-Partikel in dem erfindungsgemäß einzusetzenden Kieselsol beträgt 12 bis 300 nm, bevorzugt 30 bis 200 nm, ganz besonders bevorzugt 35 bis 90 nm. Unter der mittleren Teilchengröße ist hier der Teilchengrößendurchmesser bei d₅₀ zu verstehen, wie er mit der Ultrazentrifuge bestimmt wird.

Die erfindungsgemäße Zusammensetzung enthält im Allgemeinen 1 bis 21,5 Gew.- %, bevorzugt 3 bis 15 Gew.-% und besonders bevorzugt 5 bis 10 Gew.-% kationisch modifiziertes SiO₂.

In einer bevorzugten Ausführungsform weist das in der erfindungsgemäßen Zusammensetzung enthaltene kationisch modifizierte Kieselsol eine multimodale Größenverteilungskurve auf. Eine bekannte Messmethode zur Ermittlung der Modalität einer Suspension ist bei H. G. Müller Colloid Polym. Sci 267; 1989, S. 1113-1116 beschrieben.

Besonders bevorzugt enthält die erfindungsgemäße Zubereitung Kieselsole, die eine bimodale Teilchengrößenverteilung aufweisen, wobei vorzugsweise das Maximum A (d_{50A}) der bimodalen Teilchengrößenverteilung im Bereich 10-100 nm, das Maximum B (d_{50B}) im Bereich 40-300 nm liegt, und das Maximum A + 10 nm < Maximum B ist.

Das in der erfindungsgemäßen Zusammensetzung bevorzugt eingesetzte bimodale Kieselsol wird bevorzugt durch Mischen von monomodalen Kieselsolen hergestellt.

Das bimodale Kieselsol kann direkt während der Kieselsolsynthese erzeugt werden.

Die Oberflächenmodifizierung durch tri- oder tetravalente Metalloxide kann vor oder nach dem Mischen der Kieselsole vorgenommen werden.

Als Oxidationsmittel für die erfindungsgemäße Zusammensetzung geeignet sind z.B. HNO₃, AgNO₃, CuClO₄, H₂SO₄, H₂O₂, HOCl, KMnO₄, Ammoniumperoxodisulfat, KHSO₅, Ammoniumoxalat, Na₂CrO₄, UHP, Fe-Perchlorat, Fe-Chlorid, Fe-Citrat, Fe-Nitrat, HJO₃, KJO₃ oder HClO₃. Bevorzugt ist Wasserstoffperoxid und Ammoniumperoxodisulfat.

Bevorzugt enthält die erfindungsgemäße Zusammensetzung 0,05 bis 22 Gew.-% an mindestens einem Oxidationsmittel.

In einer bevorzugten Ausführungsform der Erfindung enthält die Zusammensetzung 3 bis 15 Vol.-% Wasserstoffperoxid. Besonders bevorzugt enthält die Zusammensetzung 5 bis 12 Vol.-% und ganz besonders bevorzugt 7 bis 10 Vol.-% Wasserstoffperoxid.

Wegen der leichteren Handhabbarkeit kann das Wasserstoffperoxid der erfindungsgemäße Zusammensetzung auch in Form von verdünnten WasserstoffperoxidLösungen zugesetzt werden.

In einer ebenfalls bevorzugten Ausführungsform enthält die erfindungsgemäße Zusammensetzung 0,1 - 6 Gew.-% Ammoniumperoxodisulfat als Oxidadionsmittel.

Der pH-Wert der erfindungsgemäßen Zusammensetzung liegt im Bereich von 2,5 bis 6. Bevorzugt ist der Bereich von 3 bis 5 und ganz besonders bevorzugt der Bereich von 3,5 bis 4,5. Der pH-Wert der Zusammensetzung wird im Allgemeinen durch Zugabe einer Base zum Kieselsol eingestellt. Die Menge an Base richtet sich dabei nach dem angestrebten pH-Wert. Als Base geeignet sind z.B. KOH, Guanidin und/oder Guanidincarbonat. Der pH-Wert der Zusammensetzung wird bevorzugt durch Zugabe einer wässrigen Lösung der Base zum Kieselsol eingestellt.

Der Na-Gehalt des kationisch modifizierten Kieselsols beträgt bevorzugt < 0,2 Gew.-% Na, besonders bevorzugt < 0,05 Gew.-% und ganz besonders bevorzugt < 0,01 Gew.-% Na.

Der erfindungsgemäßen Zusammensetzung können weitere übliche Zusätze wie z.B. Korrosionsschutzmittel für die Metalle zugesetzt werden, wie zum Beispiel Benztriazolamin.

Der erfindungsgemäßen Zusammensetzung können außerdem Komplexbildner für die Metalle zugesetzt werden, die die Metalle wasserlöslich machen, wie zum Beispiel Zitronensäure, Citrate, Aminosäuren, Asparaginsäure, Weinsäure, Bernsteinsäure und/oder ihre Alkalisalze. Bevorzugte Alkalisalze sind Na-frei.

Gegenstand der Erfindung ist weiterhin ein Verfahren zur Herstellung der erfindungsgemäßen Zusammensetzung, dadurch gekennzeichnet, dass man ein kationisch modifiziertes Kieselsol enthaltend 1 bis 21,5 Gew.-% kationisch modifizerte SiO₂-Partikel mit einer mittleren Teilchengröße von 12 bis 300 nm, mit einem pH-Wert von 2,5 bis 6, mit 0,05 bis 22 Gew.-% an mindestens einem Oxidationsmittel vermischt.

Für den Fall, dass als Oxidationsmitteln H₂O₂ verwendet wird, erfolgt dessen Zugabe vorzugsweise direkt vor dem Einsatz der erfindungsgemäßen Zusammensetzungen zum Polieren von Metall- und Metall/Dielektrikastrukturen, wobei auf ausreichende Vermischung zu achten ist. Dies kann beispielsweise durch geeignete Mischdüsen geschehen. Bevorzugt wird eine Vermischung direkt am Ort der Verwendung, d.h. kurz bevor die erfindungsgemäße Zusammensetzung als gebrauchsfertige Polierslurry auf das Poliertuch aufgebracht wird.

Gegenstand der Erfindung ist weiterhin die Verwendung der erfindungsgemäßen Zusammensetzungen als Polierslurry zum Polieren von Halbleitern, integrierten Schaltungen und microelektromechanischen Systemen.

Bei den zu polierenden Metallen handelt es sich vorzugsweise um Al, Ru, Pt, Ir, Cu und W und/oder deren Legierungen, Carbide und/oder Carbonitride.

Bei den zu polierenden Dielektrika handelt es sich vorzugsweise um SiLK™, Polyimide, fluoriertes Polyimide, diamantartige Kohlenstoffe, Polyarylether, Polyarylene, Parylen N, Cyclotene, Polynorbonene, Teflon, Silsesquioxane, SiO₂-Glas oder um SiO₂-Glas als Hauptkomponente mit den Nebenkomponenten Fluor, Phosphor, Kohlenstoff und/oder Bor.

Bei den zu polierenden Barriereschichten handelt es sich vorzugsweise um Schichten aus Ta, TaSi, TaN, TaSiN, Ti, TiN, WN, WSiN, SiC, Siliciumoxinitrid, Siliciumoxicarbid, Siliciumoxicarbonitrid und/oder Si₃N₄.

### Beispiele

### Herstellung der Kieselsole

### a) Saures Kieselsol mit 78 nm mittlerer Teilchengröße

Das verwendete Kieselsol wurde wie folgt hergestellt: In 18 kg Wasser wurden 2,25 kg Al₂(OH)₅Cl·2-3 H₂O und 0,560 kg Essigsäure (98 %-ig) vorgelegt. Anschließend wurden 21 kg Kieselsol Levasil® 50/50 %, (Bayer AG, mittlere Teilchengröße 75 nm, Feststoffgehalt 50 Gew.-%) zugegeben. Der pH-Wert lag bei 3,8.

### b) Saures, Na-armes Kieselsol mit 78 nm mittlerer Teilchengröße

Das verwendete Kieselsol wurde wie folgt hergestellt: In 4 kg Wasser wurden 2,25 kg Al₂(OH)₅Cl·2-3 H₂O und 0,560 kg Essigsäure (98 %-ig) vorgelegt. Anschließend wurden 35 kg Kieselsol Levasil® 50/30 % mit einem Na-Gehalt <100 ppm (Bayer AG, mittlere Teilchengröße 78 nm, Feststoffgehalt 30 Gew.-%) zugegeben. Der pH-Wert dieses sauren Sols betrug 3,8.

### c) Saurens,Na-armes Kieselsol mit 30 nm mittlerer Teilchengröße

Das verwendete Kieselsol wurde wie folgt hergestellt: In 4 kg Wasser wurden 2,25 kg Al₂(OH)₅Cl·2-3 H₂O und 0,560 kg Essigsäure (98 %-ig) vorgelegt. Anschließend wurden 35 kg Kieselsol Levasil® 100K/30 % mit einem Na-Gehalt <100 ppm (Bayer AG, mittlere Teilchengröße 78 nm, Feststoffgehalt 30 Gew.-%) zugegeben. Der pH-Wert dieses sauren Sols betrug 3,7.

### Polierexperimente

Die Polierexperimente wurden mit dem Polierer IPEC 372M der Fa. Westech, USA durchgeführt. Die Polierparameter sind in Tabelle 1 aufgeführt. Es wurden 150 mm Wafer mit Beschichtungen aus Cu, Ta und SiO₂ poliert. Cu und Ta wurden mit einem PVD-Verfahren (physikalische Dampfphasenabscheidung) abgeschieden, das SiO₂ durch Oxidation des Si-Wafers erzeugt.

**Tabelle 1**

| Polierer: ***IPEC 372M*** | Polierparameter A | Polierparameter B |
|---|---|---|
| Arbeitsscheiben- (Poliertuch-) Drehzahl | 42 U/min | 30 U/min |
| Polierkopf-(Wafer-)-Drehzahl | 45 U/min | 35 U/min |
| Anpressdruck | 34,5 kPa (5.0 psi) | 34,5 kPa (5.0 psi) |
| Rückseitendruck | 13,8 kPa (2.0 psi) | 27,6 kPa (4.0 psi) |
| Slurry-Flussrate | 150 ml/min | 150 ml/min |
| Poliertuch | Rodel Politex Regular E. ™ | Rodel IC 1400 |

### Beispiel 1

In dieser Versuchsreihe wurden, unter Verwendung von Kieselsolen gemäß Beispiel a), Polierslurries mit 0, 3, 5, 7 und 10 Vol.-% H₂O₂ hergestellt. Der Gehalt an SiO₂ betrug jeweils 10 Gew.-%.

Um einen Liter Polierslurry, enthaltend 10 Gew.-% SiO₂ und 10 Vol.-% H₂O₂, anzusetzen, wurde wie folgt vorgegangen:

300 ml eines 30 Gew.-% SiO₂ enthaltenden Kieselsols (ζ = 1,19 g/cm³ wurden vorgelegt und unter Rühren mit 270 ml destilliertem Wasser verdünnt. Anschließend wurden 430 ml einer 30 %-igen H₂O₂-Lösung (30 gew.-%ige Lösung, J.T. Baker, VLSI Grade) zugegeben (ζ = 1,11 g/cm³) und 10 min nachgerührt. Die Dichte der Polierslurry betrug ca. 1,1 g/cm³. Die Dichte von reinem H₂O₂ beträgt 1,41 g/cm³.

Die Herstellung der Polierslurries mit 0, 3, 5 und 7 Vol-% H₂O₂ erfolgte analog.

Nach der Herstellung der Polierslurries wurden die Wafer direkt gemäß Polierparameterset A poliert. Die Ergebnisse sind in der Tabelle 2 aufgeführt.

**Tabelle 2:**

| Konzentration H₂O₂ [Vol.-%] | Abtragsrate [Å/min] | | | Selektivität Cu: Ta | Selektivität Cu: Oxid | Selektivität Ta: Oxid |
|---|---|---|---|---|---|---|
| | Cu | Ta | SiO₂ | | | |
| 0 | 24 | - | - | - | - | - |
| 3 | 3406 | 100 | 60 | 34 | 57 | 1,7 |
| 5 | 5000 | 131 | 67 | 38 | 74 | 2,0 |
| 7 | 5820 | 140 | 69 | 42 | 84 | 2,0 |
| 10 | 7360 | 86 | 64 | 86 | 115 | 1,3 |

### Beispiel 2

In dieser Versuchsreihe wurden unter Verwendung von Kieselsolen gemäß Beispiel a) Polierslurries mit 0, 3, 5, 7, 10 und 15 Vol.-% H₂O₂ analog zu der in Beispiel 1 angegebenen Vorschrift hergestellt. Der Abrasivgehalt betrug jeweils 10 Gew.-%. Es wurden weiterhin Kieselsole mit 30 und 15 nm mittlerer Teilchendurchmesser (Levasil® 100 S/30 % und Levasil® 200 S/30 %, Bayer AG) eingesetzt.

Nach der Herstellung der Polierslurries wurden die Wafer direkt gemäß Polierparameterset B poliert. Die Ergebnisse sind in der Tabelle 3 aufgeführt.

**Tabelle 3:**

| Konzentration H₂O₂ [Vol.-%] | Abtragsrate [Å/min] | | |
|---|---|---|---|
| Kieselsol | 78 nm | 30 nm | 15 nm |
| 0 | 264 | 208 | 164 |
| 3 | 1937 | 3505 | 2104 |
| 5 | 2920 | 4041 | 3811 |
| 7 | 3762 | 6193 | 4365 |
| 10 | 4968 | 8078 | 3926 |
| 15 | 8787 | 7055 | 3418 |

### Beispiel 3

Die statische Ätzrate (SER) von Cu wurde für eine Polierslurry mit 10 Gew.-% Abrasiv und verschiedene H₂O₂-Gehalte bestimmt. Es wurde ein Na-armes Kieselsol mit 30 nm mittlerer Teilchengröße gemäß Beispiel c) verwendet. Für den rein chemischen Angriff der Polierslurry auf das Cu ist nur die Flüssigphase verantwortlich. Um einen möglichen Einfluss der Kieselsolteilchen auszuschließen (Belegung der Cu-Oberfläche mit Partikeln) wurde das Kieselsol zentrifugiert. Der in der Flüssigphase des Kieselsols verbleibende Feststoffgehalt betrug ca. 1 %. Das fehlende Feststoffvolumen wurde durch entmineralisiertes Wasser ersetzt. Mit diesem modifiziertem Kieselsol wurde die Polierslurry angesetzt. Die Ergebnisse sind in Tabelle 4 aufgetragen.

**Tabelle 4**

| Gehalte | | Lsg SER | | | | |
|---|---|---|---|---|---|---|
| H₂O₂ | H₂O₂ | H₂O₂, 30 Gew.-% | Kieselsol | H₂O | gesamt Lsg. | nm |
| [Gew.-%] | [Vol.-%] | [g] | [g] | [g] | [g] | |
| 0 | 0,00 | 0,00 | 4,76 | 15,24 | 20 | 5 |
| 3 | 2,11 | 2,00 | 4,76 | 13,24 | 20 | 11 |
| 5 | 3,55 | 3,33 | 4,76 | 11,91 | 20 | 8 |
| 7 | 5,01 | 4,67 | 4,76 | 10,57 | 20 | 5 |
| 10 | 7,24 | 6,67 | 4,76 | 8,57 | 20 | 2 |
| 14 | 10,30 | 9,33 | 4,76 | 5,91 | 20 | 2 |

## Patentansprüche

1. Zusammensetzung enthaltend 2,5 bis 70 Vol.-% eines 30 Gew.-% kationisch modifizierten Kieselsols, dessen kationisch modifizierte SiO₂-Partikel eine mittlere Teilchengröße von 12 bis 300 nm haben, sowie 0,05 bis 22 Gew.-% an mindestens einem Oxidationsmittel, mit einem pH-Wert von 2,5 bis 6.

2. Zusammensetzung gemäß Anspruch 1, **dadurch gekennzeichnet, dass** das kationisch modifizierte Kieselsol erhältlich ist durch Oberflächenmodifikation von nicht modifizierten Kieselsolen mit löslichen, tri- oder tetravalenten Metalloxiden, -oxichloriden, -oxihydraten, -nitraten, -sulfaten, -oxisulfaten und/oder -oxalaten.

3. Zusammensetzung gemäß wenigstens einem der Ansprüche 1 und 2, **dadurch gekennzeichnet, dass** sie 1 bis 21,5 Gew.-% kationisch modifizierte SiO₂-Partikel enthält.

4. Zusammensetzung gemäß wenigstens einem der Ansprüche 1 bis 3, **dadurch gekennzeichnet, dass** die kationisch modifizierten SiO₂-Partikel eine bimodale Teilchengrößenverteilung aufweisen, wobei das Maximum A der bimodalen Teilchengrößenverteilung im Bereich 10-100 nm, das Maximum B im Bereich 40-300 nm liegt, und das Maximum A + 10 nm < Maximum B ist.

5. Zusammensetzung gemäß wenigstens einem der Ansprüche 1 bis 4, **dadurch gekennzeichnet, dass** sie 0,05 bis 22 Gew.-% an mindestens einem Oxidationsmittel enthält.

6. Zusammensetzung gemäß wenigstens einem der Ansprüche 1 bis 5, **dadurch gekennzeichnet, dass** sie 3 bis 15 Vol.-% Wasserstoffperoxid enthält.

7. Zusammensetzung gemäß wenigstens einem der Ansprüche 1 bis 6, **dadurch gekennzeichnet, dass** sie 0,1 bis 6 Vol.-% Ammoniumperoxodisulfat enthält.

8. Verwendung einer Zusammensetzung gemäß wenigstens einem der Ansprüche 1 bis 7 zum Polieren von Metall- und Metall/Dielektrika-Strukturen.

9. Verwendung gemäß Anspruch 8, **dadurch gekennzeichnet, dass** es sich bei den Metallen um Al, Ru, Pt, Ir, Cu und/oder W und/oder deren Legierungen, Carbide und/oder Carbonitride handelt.

10. Verwendung gemäß wenigstens einem der Ansprüche 8 und 9, **dadurch gekennzeichnet, dass** es sich bei den Dielektrika um SiLK™, Polyimiden, fluorierten Polyimiden, diamantartigen Kohlenstoffen, Polyarylethern, Polyarylenen, Parylen N, Cyclotenen, Polynorbonenen, Teflon, Silsesquioxanen, SiO₂-Glas oder um SiO₂-Glas mit den Nebenkomponenten Fluor, Phosphor, Kohlenstoff und/oder Bor handelt.

11. Verwendung gemäß wenigstens einem der Ansprüche 8 bis 10 bei der Herstellung von Halbleitern, integrierten Schaltungen und microelektromechanischen Systemen.

12. Verfahren zur Herstellung einer Zusammensetzung gemäß Anspruch 1, **dadurch gekennzeichnet, dass** man ein kationisch modifiziertes Kieselsol enthaltend 1 bis 21,5 Gew.-% kationisch modifizerte SiO₂-Partikel mit einer mittleren Teilchengröße von 12 bis 300 nm und einem pH-Wert von 2,5 bis 6, mit 0,05 bis 22 Gew.-% an mindestens einem Oxidationsmittel vermischt.
